Europäisches Patentamt

European Patent Office

Office européen des brevets

(11) Veröffentlichungsnummer: **0 282 884 B1**

## (12) EUROPÄISCHE PATENTSCHRIFT

(45) Veröffentlichungstag der Patentschrift: **12.06.91**

(51) Int. Cl.5: **G01D 5/245**, G01D 5/249

(21) Anmeldenummer: **88103681.8**

(22) Anmeldetag: **09.03.88**

(54) **Positionsgeber.**

(30) Priorität: **18.03.87 DE 3708790**

(43) Veröffentlichungstag der Anmeldung:
**21.09.88 Patentblatt 88/38**

(45) Bekanntmachung des Hinweises auf die
Patenterteilung:
**12.06.91 Patentblatt 91/24**

(84) Benannte Vertragsstaaten:
**AT BE CH DE FR GB IT LI LU NL**

(56) Entgegenhaltungen:
**DE-A- 3 202 394**
**FR-A- 2 544 485**
**GB-A- 879 475**
**GB-A- 1 567 027**

**ELECTRONIQUE INDUSTRIELLE, Nr. 117, Dezember 1986, Seiten 45-49, "Nouvelle Serie",
Paris, FR; M. HODAPP: "Applications industrielles des codeurs optiques rotatifs incrémentiels"**

(73) Patentinhaber: **TELENORMA GMBH**
**Mainzer Landstrasse 128-146**
**W-6000 Frankfurt/Main(DE)**

(72) Erfinder: **Nezik, Dieter, Dipl.-Ing.**
**Berliner Strasse 87**
**W-6081 Stockstadt(DE)**

**Beschreibung**

Die Erfindung betrifft einen Positionsgeber, welcher in Form von Datenworten die jeweilige Lage eines eine Hintereinanderordnung von Erhebungen und Vertiefungen aufweisenden beweglichen Teils zu einem festen Teil angibt, wobei an dem beweglichen Teil eine Vielzahl von im gleichen Abstand zueinanderstehenden, durch Vertiefungen getrennten, jeweils gleichartig ausgebildeten, nockenartigen Erhebungen angebracht sind und an dem festen Teil ein Sensor angebracht ist, welcher aus dem Vorhandensein einer Erhebung bzw. einer Vertiefung unterschiedliche Signale erzeugt.

Positionsgeber werden in erster Linie überall dort verwendet, wo die augenblickliche Lage eines beweglichen Teils bezogen auf ein festes Teil festgestellt werden soll, damit von einer Steuereinrichtung die Einwirkung von Kräften auf das bewegliche Teil veranlaßt werden kann, um es auf diese Weise in eine gewünschte Position zu bringen. Die Bewegung des beweglichen Teils kann nun beispielsweise in einer Ebene auf einem geraden Weg oder auch kreisförmig erfolgen. Als Anwendungsfall für einen derartigen Positionsgeber kommt beispielsweise ein Roboter in Frage, bei welchem im Rahmen von Bewegungsvorgängen ständig die augenblickliche Lage eines beweglichen Teils desselben in Form eines Ist-Wertes durch einen Positionsgeber ermittelt wird, damit dann die steuernde Einrichtung einen Vergleich mit einem vorgegebenen Soll-Wert vornehmen kann, um daraus dann weitere Steuerbefehle ableiten zu können. Ein weiteres Anwendungsgebiet ist der Einsatz derartiger Positionsgeber bei fernsteuerbaren Uhren, deren Zeigerstellung jederzeit durch den Positionsgeber markierbar ist.

In der DE-PS 22 52 745 wird ein Verfahren zur laufenden Übermittlung der Uhrzeit beschrieben, bei welchem Codierscheiben starr mit den Zeigerwellen einer Analoguhr verbunden sind. Über den Aufbau und die Wirkungsweise der Codierscheiben läßt sich dieser Druckschrift nichts entnehmen.

Ein Positionsgeber gemäß dem Oberbegriff des Patentanspruchs 1 ist bereits bekannt. So wird in der FR-OS 2 544 485 ein Sensor zur Bestimmung der Winkelposition zweier zueinander stehender Teile beschrieben, von denen der eine Teil fest und das andere Teil beweglich ist. Der Sensor besteht aus einer am einen Ende befestigten Zunge aus piezoelektrischen Material, wobei das andere Ende durch Erhebungen in eine erste Lage gebracht wird und durch eine Vertiefung die Möglichkeit erhält, in die Ruhelage zurückzukehren. Nachteilig bei einer derartigen Anordnung ist die mechanische Beeinflussung, welche nicht nur Abnutzungserscheinungen zur Folge hat, sondern darüber hinaus auch noch Kräfte benötigt werden, um den Sensor mechanisch zu beeinflussen.

Der Erfindung liegt die Aufgabe zugrunde, einen Sensor für einen Positionsgeber anzugeben, welcher keinen Abnutzungserscheinungen unterworfen ist.

Diese Aufgabe wird dadurch gelöst, daß der Sensor als Quarzschwinger ausgebildet ist und daß der bewegliche Teil und der Quarzschwinger so ausgebildet und angeordnet sind, daß durch jede nockenartige Erhebung der Schwingungsweg des an dem festen Teil angebrachten Quarzschwingers begrenzt wird.

Eine weitere Ausbildung der Erfindung besteht darin, daß der Quarzschwinger als Stimmgabel ausgebildet ist und die Erhebungen zwischen die Schenkelenden der Stimmgabel ragen.

Die Begreuzung des Schwingungsweges der Stimmgabel erfolgt durch das Vorhandensein einer Erhebung zwischen den Stimmgabelenden.

Vorteilhafte Weiterbildungen der Erfindung ergeben sich aus den abhängigen Ansprüchen.

Die Erfindung wird anhand eines Ausführungsbeispiels näher erläutert, welches in der Zeichnung dargestellt ist. Es zeigt:

Fig. 1     die perspektivische Darstellung eines Sensors für einen Winkelcodierer und

Fig. 2     die Draufsicht mit einem als Quarzschwinger ausgebildeten Wandler.

Bei dem Ausführungsbeispiel wird davon ausgegangen, daß der Positionsgeber als Winkelcodierer für eine drehbare Welle ausgebildet ist. Die Erfindung läßt sich auch auf Positionsgeber anwenden, welche die Lage eines in einer Ebene geradlinig bewegbaren Teils angeben.

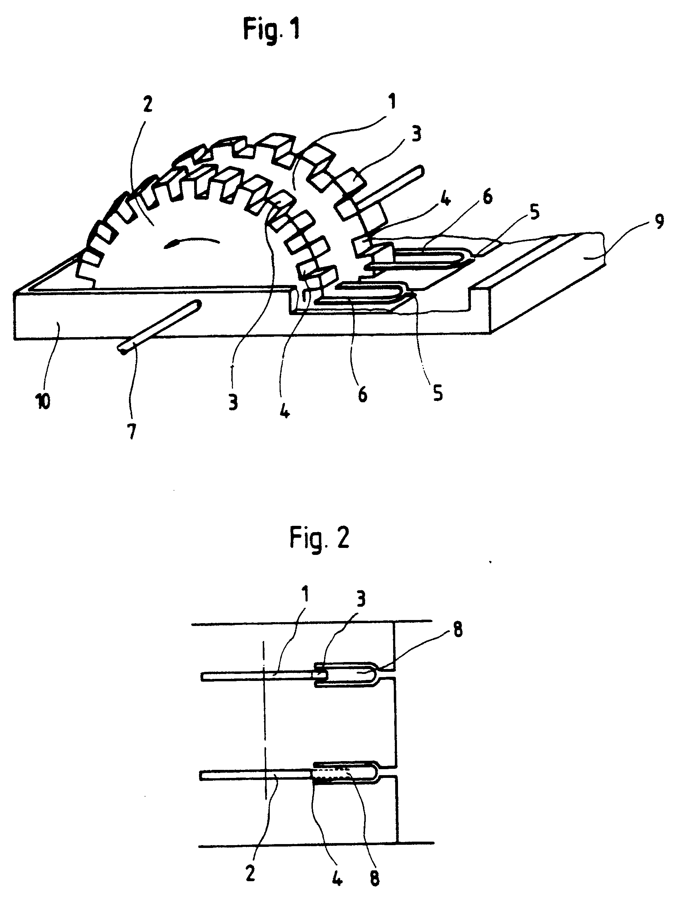

Fig 1 zeigt einen Materialblock 9, welcher aus Keramik, Quarz oder einem ätzbaren piezoelektrischen Material gebildet ist. Aus dem Materialblock 9 sind Wandler 5 herausgeformt, welche im vorliegenden Ausführungsbeispiel als stimmgabelförmige Quarzschwinger ausgebildet sind. Anstelle der Quarzschwinger 8 können jedoch auch Biegestäbe aus Quarz oder aus Piezokeramik verwendet werden. Das Herausätzen von Zungen aus Materialblöcken von Silizium oder Keramik ist an sich bekannt. (s. Elektronik-Produktion-und Prüftechnik März 1983, Seite 110 und 112).

Aus dem Materialblock 9 sind weiterhin Seitenwände 10 herausgearbeitet, die mit Durchgangslöchern zur Aufnahme einer durchgehenden Welle 7 versehen sind. Auch die Durchgangslöcher können in Ätztechnik hergestellt werden.

Auf der Welle 7 sind mehrere Codierscheiben starr befestigt, von denen in der abgebrochenen Darstellung in Fig. 1 die Codierscheiben 1 und 2 gezeigt werden. Die Codierscheiben besitzen nockenförmige Erhebungen 3 und Vertiefungen 4, die auf dem Umfang der Codierscheiben 1 und 2 angeordnet sind.

Bezüglich der Codierscheiben sind mehrere Ausführungsformen denkbar. Ist das Auflösungsvermögen, d. h. die Genauigkeit eines Winkelcodierers bereits durch den herstellbaren Abstand der Erhebungen 3 und Vertiefungen 4 ausreichend, so genügt bereits eine Codierscheibe, deren Erhebungen 3 beim Passieren des Wandlers 5 von einer nicht gezeigten Einrichtung gezählt werden. Voraussetzung hierbei ist jedoch, daß entweder die Codierscheibe zusätzlich mit einer Bezugsmarke versehen ist, bei welcher der Zählvorgang beginnt, oder die nicht gezeigte Einrichtung bei einer bestimmten Stellung der Welle 7 ein Signal von außen erhält, welches den Beginn des Zählvorgangs kennzeichnet. Diese nicht gezeigte Einrichtung arbeitet somit als Zähler, wobei die binär-codierte Zählerstellung die augenblickliche Winkelstellung der Welle 7 in Form eines die Stellung kennzeichnenden Datenwortes angibt.

Wird nun eine Genauigkeit in der Winkelangabe verlangt, welche durch das Rastermaß der Erhebungen und Vertiefungen auf der Codierscheibe nicht erreichbar ist, so können auch mehrere Codierscheiben auf der Welle 7 angebracht werden, wobei die Codierscheiben jeweils den gleichen Aufbau besitzen und derart gegeneinander versetzt sind, daß innerhalb einer Vertiefung einer Scheibe die Erhöhungen der anderen Scheiben stufenweise versetzt sind. In diesem Fall ist für jede Codierscheibe ein individueller Wandler 5 vorgesehen, welcher mit einer zugeordneten Zähleinrichtung fest verbunden ist. Der Wert des jeweiligen Winkels läßt sich aus der Zählerstellung der Zähleinrichtungen errechnen.

Eine weitere Möglichkeit in der Ausbildung der Codierscheiben besteht darin, daß für jede Bitstelle des eine Winkelstellung der Welle 7 kennzeichnenden Datenwortes eine eigene Codierscheibe vorgesehen ist, wobei die Erhebungen und Vertiefungen auf den einzelnen Codierscheiben entsprechend der Wertigkeit der Bitstelle angebracht sind. Dies kann beispielsweise in Form eines Binärcodes erfolgen. In diesem Fall können die Ausgangssignale der einzelnen Wandler 5 direkt zur Bildung der die Winkelstellung kennzeichnenden Datenworte herangezogen werden. Soll z. B. die Winkelstellung durch ein Datenwort von 4 Bit Länge dargestellt werden, so sind in diesem Fall vier Codierscheiben notwendig, wobei die erste Codierscheibe der Binärstelle $2^0$, die zweite Codierscheibe der Bitstelle $2^1$, die dritte Codierscheibe der Bitstelle $2^2$ und die vierte Codierscheibe der Bitstelle $2^3$ entspricht. Dabei weist die Codierscheibe für die niederwertigste Bitstelle 8 Erhebungen 3 und 8 Vertiefungen 4 auf, während die Codierscheibe für die höchstwertigste Bitstelle lediglich eine Erhöhung und eine gleich lange Vertiefung aufweist.

Die Wandler 5 sind als Stimmgabelschwinger ausgebildet, wobei die Erhebungen bzw. Vertiefungen zwischen den Schenkeln der Gabeln liegen. Befindet sich eine Erhebung 3 zwischen den Schenkeln einer Gabel des Stimmgabelschwingers 5, so kann dieser nicht schwingen und gibt somit kein Signal ab. Befindet sich dagegen eine Vertiefung zwischen den beiden Schenkeln, so ist die Schwingung der Stimmgabelschwinger 5 freigegeben, worauf der Stimmgabelschwinger 5 ein Signal abgibt.

Die Codierscheiben 1,2 bestehen aus einem abriebfesten, möglichst gießfähigen Material, wie beispielsweise einem aushärtbaren Kunststoff.

In Fig. 2 wird gezeigt, wie eine Erhebung 3 einer Codierscheibe 1 in den Schwingungsbereich der Schenkel einer Stimmgabel 8 eines Wandlers 5 hineinragt und damit die Schwingung der Stimmgabel blockiert. Hinsichtlich der Codierscheibe 2 liegt gerade eine Vertiefung vor dem Schenkel einer anderen Stimmgabel 8, so daß diese frei schwingen kann. Erfolgt die Bewegung der Codierscheiben 1,2 schrittweise, beispielsweise bei einer Zeigerwelle einer Uhr, so kann die Erregerspannung für die Quarzschwinger nur während des Stillstandes der Codierscheiben eingeschaltet werden.

Die nicht gezeigte Einrichtung kann von außen einen Sollwert in Form eines Datenworts erhalten, worauf diese dann den Sollwert mit dem Istwert, der aus den Wandlersignalen 5 abgeleitet worden ist, vergleicht. Dabei kann für die Dauer der Ungleichheit ein Steuersignal erzeugt werden, durch welches eine Drehbewegung der Welle 7 ausgelöst wird, um diese auf eine vorbestimmte Stellung zu bringen, welche beispielsweise dem vorgegebenen Sollwert entspricht.

## Ansprüche

1. Positionsgeber, welcher in Form von Datenworten die jeweilige Lage eines eine Hintereinanderordnung von Erhebungen (3) und Vertiefungen (4) aufweisenden beweglichen Teils (7) zu einem festen Teil (9) angibt, wobei an dem beweglichen Teil (7) eine Vielzahl von im gleichen Abstand zueinanderstehenden, durch Vertiefungen (4) getrennten, jeweils gleichartig ausgebildeten, nockenartigen Erhebungen (3) angebracht sind und an dem festen Teil ein Sensor (5) angebracht ist, welcher aus dem Vorhandensein einer Erhebung bzw. einer Vertiefung unterschiedliche Signale erzeugt, dadurch gekennzeichnet, daß der Sensor (5) als Quarzschwinger ausgebildet ist und daß der bewegliche Teil (7) und der Quarzschwinger (5) so ausgebildet und angeordnet sind, daß durch jede nockenartige Erhebung (3) der Schwingungsweg der an dem festen Teil (9) angebrachten Quarzschwingers begrenzt wird.

2. Positionsgeber nach Anspruch 1,
dadurch gekennzeichnet,
daß der Quarzschwinger als Stimmgabel (8) ausgebildet ist und die Erhebungen (3) zwischen die Schenkelenden der Stimmgabel (8) ragen.

3. Positionsgeber nach Anspruch 1 oder 2,
dadurch gekennzeichnet,
daß die Erhebungen (3) und Vertiefungen (4) an einer, an einer drehbaren Welle (7) befestigten Codierscheibe (1,2) angebracht sind.

4. Positionsgeber nach einem der Ansprüche 1 bis 3,
dadurch gekennzeichnet,
daß mehrere Codierscheiben (1, 2) nebeneinander auf der drehbaren Welle (7) derart angebracht sind, daß die Erhebungen (3) der Codierscheiben (1,2) gegeneinander versetzt sind.

5. Positionsgeber nach einem der Ansprüche 1 bis 3,
dadurch gekennzeichnet,
daß mehrere Codierscheiben (1,2) nebeneinander auf der drehbaren Welle (7) angebracht sind, wobei die Erhebungen (3) und Vertiefungen (4) auf den einzelnen Codierscheiben (1,2) derart angeordnet sind, daß sie jeweils der Bitstelle eines Binärcodes entsprechen.

6. Positionsgeber nach einem der Ansprüche 1 bis 5,
dadurch gekennzeichnet,
daß die Bewegung der Codierscheibe (-n) (1,2) schrittweise erfolgt und daß die Stimmgabel/n (8) nur während des Stillstandes der Codierscheibe (1,2) erregt wird bzw. werden.

7. Positionsgeber nach einem der Ansprüche 1 bis 6,
dadurch gekennzeichnet,
daß ein oder mehrere Quarzschwinger bzw. Stimmgabel/n (8) durch Anwendung von Ätztechniken aus einem gemeinsamen Materialblock (9) herausgeformt sind.

8. Positionsgeber nach Anspruch 1,
dadurch gekennzeichnet,
daß der Materialblock (9) die Lager für die Welle (7) bildet.

9. Positionsgeber nach einem der Ansprüche 1 bis 8,
dadurch gekennzeichnet,
daß die elektrischen Ausgangssignale der Quarzschwinger bzw. Stimmgabeln (8) einem Umrechner, vorzugsweise einem Mikroprozessor, zugeführt werden, in welchem die die aktuelle Winkelstellung der Welle (7) kennzeichnenden Signale in einen Code umgesetzt werden.

10. Positionsgeber nach Anspruch 9,
dadurch gekennzeichnet,
daß der die Winkelstellung der Welle (7) kennzeichnende Code mit einem Sollwert verglichen wird und daß bei einem Unterschied zwischen der aktuellen Winkelstellung der Welle (7) und dem Sollwert von dem Umrechner ein Signal erzeugt wird.

## Claims

1. Position transducer which in the form of data words indicates the respective position of a movable part (7), which displays an arrangement of protrusions (3) and depressions (4) one behind the other, relative to a fixed part (9), wherein a plurality of doglike protrusions (3), which stand one at the same spacing from the other and are separated by depressions (4) and which are each constructed indentically, are arranged at the movable part (7) and a sensor (5), which produces different signals respectively from the presence of either a protrusion or a depression, is mounted at the fixed part, characterised thereby, that the sensor (5) is constructed as quartz oscillator and that the movable part (7) and the quartz oscillator (5) are so constructed and arranged that the oscillatory travel of the quartz oscillator mounted at the fixed part (9) is limited by each doglike protrusion (3).

2. Position transducer according to claim 1, characterised thereby, that the quartz oscillator is constructed as tuning fork (8) and the protrusions (3) project between the tine ends of the tuning fork (8).

3. Position transducer according to claim 1 or 2, characterised thereby, that the protrusions (3) and depressions (4) are arranged at a coding disc (1, 2) fastened at a rotatable shaft (7).

4. Position transducer according to one of the claims 1 to 3, characterised thereby, that several coding discs (1, 2) are mounted one beside the other on the rotatable shaft (7) in such a manner that the protrusions (3) of the coding discs (1, 2) are displaced one relative to the other.

5. Position transducer according to one of the claims 1 to 3, characterised thereby, that several coding discs (1, 2) are mounted one beside the other on the rotatable shaft (7), wherein the protrusions (3) and the depression (4) are arranged on the individual coding discs (1, 2) in such a manner that they each correspond to the bit position of a binary code.

6. Position transducer according to one of the claims 1 to 5, characterised thereby, that the movement of the coding disc or discs (1, 2) takes place in stepwise manner and that the tuning fork or forks (8) is or are excited only during the standstill of the coding disc (1, 2).

7. Position transducer according to one of the claims 1 to 6, characterised thereby, that one or more quartz oscillators or tuning forks (8) are shaped out of a common material block (9) by the application of etching techniques.

8. Position transducer according to claim 1, characterised thereby, that the material block (9) forms the bearing for the shaft (7).

9. Position transducer according to one of the claims 1 to 8, characterised thereby, that the electrical output signals of the quartz oscillators or tuning forks (8) are fed to a translator, preferably a microprocessor, in which the signals characterising the actual angular setting of the shaft (7) are translated into a code.

10. Position transducer according to claim 9, characterised thereby, that the code characterising the angular setting of the shaft (7) is compared with a target value and that a signal is produced by the translator in the case of a difference between the target value and the actual angular setting of the shaft (7).

## Revendications

1. Transmetteur de position, qui indique, sous la forme de mots de données, la position respective d'une partie mobile (7), comportant un ensemble en série d'élévations (3) et de renfoncements (4), par rapport à une partie fixe (9), et dans lequel une multiplicité d'élévations identiques équidistantes en forme de cames (30), qui sont séparées par des renfoncements (4), sont installées sur la partie mobile (7), tandis que sur la partie fixe est installé un capteur (5) qui produit des signaux différents, en raison de la présence d'une élévation ou d'un renfoncement, caractérisé en ce que le capteur (5) est réalisé sous la forme d'un oscillateur à quartz et que la partie mobile (7) et l'oscillateur à quartz (5) sont agencés et disposés de telle sorte que l'amplitude d'oscillation de l'oscillateur à quartz installé sur la partie fixe (9) est limitée par chaque élévation en forme de came.

2. Transmetteur de position selon la revendication 1, caractérisé en ce que l'oscillateur à quartz est réalisé sous la forme d'un diapason (8) et que les élévations (3) font saillie entre les extrémités des branches du diapason (8).

3. Transmetteur de position selon la revendication 1 ou 2, caractérisé en ce que les élévations (3) et les renfoncements (4) sont disposés sur un disque de codage (1,2) fixé à un arbre rotatif (7).

4. Transmetteur de position selon l'une des revendications 1 à 3, caractérisé en ce que plusieurs disques de codage (1,2) sont disposés côte-à-côte sur l'arbre rotatif (7) de telle sorte que les élévations (3) des disques de codage (1,2) sont décalées les unes par rapport aux autres.

5. Transmetteur de position selon l'une des revendications 1 à 3, caractérisé en ce que plusieurs disques de codage (1,2) sont disposés côte-à-côte sur l'arbre rotatif (7), les élévations (3) et les renfoncements (4) étant disposés sur les différents disques de codage (1,2) de telle sorte qu'ils correspondent aux positions binaires respectives d'un code binaire.

6. Transmetteur de position selon l'une des revendications 1 à 5, caractérisé en ce que le déplacement du ou des disques de codage (1,2) s'effectue pas-à-pas et que le ou les diapasons (8) sont excités uniquement lorsque le ou les disques de codage (1,2) sont à l'arrêt.

7. Transmetteur de position selon l'une des revendications 1 à 6, caractérisé en ce qu'un ou plusieurs oscillateurs à quartz ou diapasons (8) sont formés à partir d'un' bloc de matériau commun (9), moyennant l'utilisation de techniques de corrosion.

8. Transmetteur de position selon la revendication 1, caractérisé en ce que le bloc de matériau (9) forme les paliers pour l'arbre (7).

9. Transmetteur de position selon l'une des revendications 1 à 8, caractérisé en ce que les signaux électriques de sortie des oscillateurs à quartz ou des diapasons (8) sont envoyés dans un dispositif de conversion, de préférence un microprocesseur, dans lequel les signaux caractérisant la position angulaire de l'arbre (7) sont convertis en un code.

10. Transmetteur de position selon la revendication 9, caractérisé en ce que le code caractérisant la position angulaire de l'arbre (7) est comparé à une valeur de consigne et que, dans le cas d'une différence entre la position angulaire réelle de l'arbre (7) et la valeur de consigne, un signal est produit par le dispositif de conversion.

## Fig. 1

## Fig. 2